Europäisches Patentamt

European Patent Office

Office européen des brevets

(11) Veröffentlichungsnummer: **0 060 805**
**B1**

(12) **EUROPÄISCHE PATENTSCHRIFT**

(45) Veröffentlichungstag der Patentschrift:
29.01.86

(21) Anmeldenummer: 82730034.4

(22) Anmeldetag: 15.03.82

(51) Int. Cl.⁴: **H 05 K 3/26, C 23 F 1/02, H 01 B 5/14, B 44 C 1/22**

(54) **Herstellverfahren für und nach diesem Verfahren hergestellte Leiterplatten.**

(30) Priorität: 18.03.81 DE 3110415

(43) Veröffentlichungstag der Anmeldung:
22.09.82 Patentblatt 82/38

(45) Bekanntmachung des Hinweises auf die Patenterteilung:
29.01.86 Patentblatt 86/5

(84) Benannte Vertragsstaaten:
AT CH FR GB IT LI SE

(56) Entgegenhaltungen:
AT - B - 346 957
DE - A - 2 337 032
DE - B - 2 030 013
DE - B - 2 240 502

(73) Patentinhaber: KOLLMORGEN TECHNOLOGIES CORPORATION, Republic National Bank Building 60 Washington Street, Hartford Connecticut 06106 (US)

(72) Erfinder: Stahl, Fritz, Viersener Strasse 163, D-4154 Tönisvorst (DE)
Erfinder: Steffen, Horst, Dr., Antoniusstrasse 31, D-4170 Geldern-Pont (DE)

(74) Vertreter: Meinig, Karl-Heinz et al, PATENTANWÄLTE-PFENNING-MAAS-MEINIG-SPOTT Kurfürstendamm 170, D-1000 Berlin 15 (DE)

## Beschreibung

Die vorliegende Erfindung betrifft verbesserte Verfahren zum Herstellen von Leiterplatten, ausgehend von Isolierstoffträgern, die nicht mit einer Metall-, beispielsweise einer Kupferfolie, kaschiert sind und im nachfolgenden als Basismaterial bezeichnet werden, und Leiterplatten, die nach solchen Verfahren hergestellt werden. Bei derartigen, unter den Bezeichnungen «Voll-Additiv»- bzw. «Semi-Additiv»-Verfahren bekanntgewordenen Herstellprozessen wird beispielsweise von Phenolharzpapier-Laminaten, glasfaserverstärkten Epoxydharz-Schichtpressstoffen und dergleichen ausgegangen. Um eine verlässliche Verankerung von beispielsweise durch stromlose Metallabscheidungsprozesse hergestellten Leiterzügen auf solchen Basismaterialien zu erzielen, ist es bekannt, deren Oberfläche mit Haftvermittlerschichten, beispielsweise entsprechend der DE-PS 1 665 314, zu versehen, nach dem Aufbringen einer solchen Schicht die Oberfläche zumindest teilweise auszuhärten und anschliessend durch Behandlung mit geeigneten Badlösungen benetzbar und mikroporös zu machen. Auf der so vorbereiteten Oberfläche wird sodann das gewünschte Leiterzugmuster mittels bekannter Metallabscheidungsverfahren aufgebaut.

Mit den insbesondere bei Leiterplatten mit sehr geringen Abständen zwischen benachbarten Leiterzügen, sogenannten Feinleiterplatten, gestiegenen Anforderungen an den Oberflächenisolationswiderstand hat es sich bei den bekanntgewordenen Verfahren als nachteilig erwiesen, dass die mit Haftvermittlerschichten erzielbaren Werte nicht an jene Oberflächenwiderstände heranreichen, wie sie beispielsweise für nicht mit Haftvermittler beschichtete Epoxydharzlaminate oder Polyimide typisch sind bzw. für Feinleiterplatten gewünscht werden.

Wird in bekannter Weise entsprechend der DE-A 2 337 032 der als Basismaterial dienende Isolierstoffträger mit einem üblichen Haftvermittler auf Phenolharz/Gummibasis beschichtet, dieser ausgehärtet und durch Behandlung mit einer Chromschwefelsäurelösung polar und mikroporös gemacht und die Haftvermittlerschichtoberfläche anschliessend mit einer Metallionen, beispielsweise Zinn/Palladium-Verbindungen enthaltenden Katalysatorlösung behandelt, so werden diese Verbindungen adsorptiv an der Oberfläche angelagert und bilden so, gegebenenfalls nach entsprechender Behandlung, für die stromlose Metallabscheidung katalytisch wirksame Zentren. Dies erfolgt in der Regel durch Behandlung mit geeigneten Spülbädern, die einmal den Überschuss der Katalysatorlösung entfernen, und zum anderen die Überführung der Palladiumverbindungen in katalytisch besonders wirksame Keime bewirken. Gleichzeitig kommt es zur Hydrolyse der Zinnverbindungen. Das Hydrolyseprodukt wird gleichfalls an der Oberfläche angelagert.

Bei dem Semi-Additiv-Verfahren wird sodann eine relativ dünne Metallschicht, in der Regel eine Kupferschicht, aus bekannten, ohne äussere Stromzufuhr arbeitenden Metallisierungsbädern abgeschieden.

Nach dem Aufbringen einer dem Negativ des gewünschten Leiterbildes entsprechenden Abdeckmaske wird dann in bekannter Weise, in der Regel galvanisch, in den nicht abgedeckten Flächen Kupfer bis zur gewünschten Dicke abgeschieden. Falls erwünscht, kann hierauf die Abscheidung anderer Metalle, wie Nickel, Gold oder lötfähiger Zinn/Blei-Legierungen erfolgen.

Sollen Leiterplatten mit beidseitigem Leiterzugmuster und Löchern mit metallisierten Lochwandungen hergestellt werden, so werden die Löcher bereits vor dem Katalysieren angebracht, und im übrigen wird in analoger Weise, wie oben beschrieben, verfahren. Hierauf wird die Abdeckmaskenschicht entfernt und die dünne, stromlos aufgebrachte Kupferschicht mittels eines zeitlich entsprechend bemessenen Ätzschrittes entfernt.

Es hat sich gezeigt, dass sich durch die angelagerten, auch durch den Kupferätzschritt nicht entfernten Katalysatorreste einschliesslich der Zinnverbindungen der Oberflächenwiderstand noch in beträchtlichem Umfang über den für den Haftvermittler selbst geltenden Wert hinaus verschlechtert. Dieser Effekt tritt besonders dann störend auf, wenn Haftvermittlerschichten mit Zusammensetzungen verwendet werden, die an sich noch relativ gute Oberflächenwiderstände erbringen.

Es hat in der Vergangenheit nicht an Versuchen gefehlt, die Oberfläche des Haftvermittlers durch Nachbehandlung mit Reinigungslösungen von den angelagerten Produkten zu befreien. Aus der AT-B-346 957 ist beispielsweise ein Verfahren zum Entfernen von bei der Lochherstellung verschmierten Kunstharzresten aus der Lochinnenwand der gedruckten Schaltung bekannt, nach dem die Leiterplatten in einer Lösung, die 10 bis 75 g/l $KMnO_4$ und NaOH enthält, für 15 bis 55 min. bei einer Temperatur zwischen 40 und 70°C, vorzugsweise 60°C, behandelt werden. Alle diese Versuche haben, wie es sich gezeigt hat, nicht zu brauchbaren Ergebnissen geführt.

Nach der vorliegenden Erfindung werden die oben beschriebenen Nachteile dadurch vollkommen vermieden, dass nach der Fertigstellung des Leiterzugmusters die zwischen den Leiterzügen befindliche Haftvermittlerschicht zum Teil oder vollständig entfernt wird.

Ätzlösungen wie die zum Herstellen der polaren und mikroporösen Haftvermittler-Oberflächenschicht benutzte Chromschwefelsäure führt zum Abtrag des Leiterzug-Kupfers und vor allem in störender Weise zur Unterätzung der Leiterzüge.

Entsprechend der vorliegenden Erfindung werden diese Nachteile vollständig vermieden, wenn zum Entfernen des Haftvermittlers eine alkalische Permanganatlösung bzw. eine Chromsäurelösung verwendet wird. Diese entfernen die Haftvermittlerschicht nach Wunsch teilweise oder vollkommen, ohne dass nachteilige Einwirkungen festgestellt werden können.

Durch die Verwendung der erfindungsgemässen Lösungen zum Abtragen des Haftvermittlers wird also in überraschender Weise erreicht, dass ohne jede nachteilige Wirkung auf Basismaterial und Leiterzüge und deren Verankerung der Oberflächenwiderstand wesentlich verbessert und erforderlichenfalls bis auf den Wert des verwendeten Basismaterials selbst gebracht wird.

Beispiel 1

Eine in bekannter Weise auf einem mit Haftvermittler beschichteten Basismaterial nach dem Semi-Additiv-Verfahren hergestellte gedruckte Leiterplatte weist typisch, und je nach verwendetem Haftvermittler, einen Oberflächenwiderstand von beispielsweise $1,3 \times 10^9$ Ohm auf.

Entsprechend der Erfindung wird die Leiterplatte zur Verbesserung des Oberflächenwiderstandes mit einer wässrigen Lösung, die 50 g/l $KMnO_4$ und 50 g/l NaOH enthält, für 5 Minuten bei einer Badtemperatur von 55 bis 60°C unter Badbewegung durch Rühren behandelt. Anschliessend wird für 1 Minute in Wasser gespült, gefolgt von einem 2-minütigem Spülen in einer 20%igen Salzsäurelösung bei Raumtemperatur. Die Säurebehandlung bewirkt, dass die auf der Oberfläche gebildeten Manganverbindungen gelöst werden. Anstelle von Salzsäure können auch andere geeignete Lösungsmittel wie Oxalsäure bzw. Hydrazinhydrat verwendet werden. Nach der Säurebehandlung wird zunächst in Leitungs- und anschliessend in deionisiertem Wasser gespült und die Platte getrocknet. Der dann gemessene Oberflächenwiderstand betrug $5 \times 10^{10}$ Ohm.

Die alkalische Permanganatlösung wird immer dann vorteilhafterweise verwendet, wenn bevorzugt lediglich eine durch den Katalysierungsvorgang verunreinigte Schicht des Haftvermittlers abgetragen werden soll. Bei der Behandlung mit der alkalischen Permanganatlösung wird der Haftvermittler durch das 7-wertige Mangan oxidiert, wobei sich 4-wertiges Mangan bildet, das auf der Haftvermittlerschicht fest verankert wird und so einen weiterschreitenden Angriff verhindert.

Soll ein weiterer Abtrag erfolgen, muss zunächst diese Schicht entfernt und die übrigen Verfahrensschritte entsprechend wiederholt werden.

Wird anstelle der alkalischen Permanganatlösung eine wässrige Chromsäurelösung benutzt, so kann der Haftvermittler in den freiliegenden Gebieten bei entsprechender Einwirkungsdauer quantitativ entfernt werden.

Beispiel 2

Die gedruckte Leiterplatte nach Beispiel 1 wird anstelle der dort beschriebenen Behandlung für 2 Minuten mit einer Lösung von 900 g $CrO_3$ in $H_2O$ bei einer Badtemperatur von 50°C behandelt. Anschliessend wird die Leiterplatte mit einer Lösung, die ein Reduktionsmittel für 6-wertiges Chrom enthält, wie beispielsweise Eisen(II)sulfat oder Natriumsulfit, behandelt, in Leitungswasser und anschliessend in deionisiertem Wasser gespült und getrocknet. Durch diese Behandlung wurde die ca. 30 μ starke Haftvermittlerschicht vollkommen entfernt.

Der gemessene Oberflächenwiderstand betrug $10^{12}$ Ohm, wurde also gegenüber dem Ausgangszustand um fast drei Zehnerpotenzen verbessert.

Es können somit nach dem Verfahren nach der vorliegenden Erfindung Leiterplatten hergestellt werden, die allen derzeit bestehenden und für die Zukunft absehbaren Ansprüchen voll genügen.

Patentansprüche

1. Verfahren zum Herstellen von Leiterplatten nach dem Semi-Additiv-Verfahren, bei dem ein Basismaterial mit einem Haftvermittler versehen und dessen mikroporöse Oberfläche mit einer Metallionen enthaltenden Katalysatorlösung behandelt wird, dadurch gekennzeichnet, dass nach der Herstellung der Leiterzüge in einem nachfolgenden Verfahrensschritt die zwischen den Leiterzügen freiliegende Haftvermittlerschicht zum Teil bzw. zur Gänze und ohne bzw. praktisch ohne Angriff auf das Basismaterial und die Leiterzüge abgetragen wird.

2. Verfahren nach Anspruch 1, dadurch gekennzeichnet, dass zum Abtragen eine alkalische Permanganatlösung oder eine Chromsäurelösung verwendet wird.

3. Verfahren nach Anspruch 2, dadurch gekennzeichnet, dass das mit Leiterzügen versehene Basismaterial zunächst mit einer alkalischen Permanganatlösung behandelt wird, sodann die Manganverbindungs-Rückstände von der Oberfläche vollkommen entfernt und diese anschliessend gespült wird.

4. Verfahren nach Anspruch 3, dadurch gekennzeichnet, dass das mit Leiterzügen versehene Basismaterial

a) in einer wässrigen Lösung, die 50 g/l $KMnO_4$ und 50 g/l NaOH enthält, für 5 Minuten bei 55 bis 60°C, und

b) nach dem Abspülen mit Wasser für 2 Minuten mit einer 20%igen Salzsäurelösung behandelt, und

c) anschliessend zunächst in Leitungswasser und danach in deionisiertem Wasser gespült und dann getrocknet wird.

5. Verfahren nach Anspruch 4, dadurch gekennzeichnet, dass in Schritt (b) anstelle der 20%igen Salzsäurelösung eine Lösung benutzt wird, die Oxalsäure, Hydrazinhydrat bzw. eine andere, zum Entfernen der Manganverbindungen geeignete Verbindung enthält.

6. Verfahren nach Anspruch 3, dadurch gekennzeichnet, dass die Verfahrensschritte zum Abtragen der Haftvermittlerschicht bis zum Erzielen des gewünschten Abtrages bzw. bis zum vollständigen Entfernen der Haftvermittlerschicht wiederholt werden.

7. Verfahren nach Anspruch 2, dadurch gekennzeichnet, dass das mit Leiterzügen versehene Basismaterial zunächst mit einer wässrigen Chromsäurelösung behandelt wird, dass anschliessend Reaktionsrückstände wie 6-wertige Chromverbindungen entfernt werden und sich daran ein Spül- sowie ein Trockenschritt anschliesst.

8. Verfahren nach Anspruch 7, dadurch gekennzeichnet, dass zum Entfernen der Reaktionsrückstände eine Lösung benutzt wird, die ein Reduktionsmittel für 6-wertiges Chrom enthält.

9. Verfahren nach Anspruch 8, dadurch gekennzeichnet, dass das Reduktionsmittel Eisen(II)sulfat oder Natriumsulfit bzw. Formaldehyd enthält.

10. Verfahren nach einem der Ansprüche 7 bis 9, dadurch gekennzeichnet, dass das mit Leiterzügen versehene Basismaterial

A) für 2 Minuten bei einer Badtemperatur von 50°C mit einer Lösung von 900 g $CrO_3$ in Wasser behandelt,

B) anschliessend in Wasser gespült, und nach einer Behandlung mit einer Eisen(II)sulfat- oder Natriumsulfit- bzw. Formaldehyd-Lösung

C) zunächst in Leitungswasser und anschliessend in deionisiertem Wasser gereinigt und getrocknet wird.

11. Leiterplatten nach Art gedruckter Schaltungen, deren Leiterzüge durch Metallbeschichtung bzw. -aufbau auf mit einer Haftvermittlerschicht versehenem Basismaterial entsprechend Anspruch 1 hergestellt sind, dadurch gekennzeichnet, dass die Haftvermittlerschicht auf der Oberfläche zwischen den Leiterzügen zumindest teilweise abgebaut ist.

12. Leiterplatten nach Anspruch 11, dadurch gekennzeichnet, dass die Oberfläche zwischen den Leiterzügen frei von Haftvermittler ist.

## Claims

1. Method for making printed circuit boards by the fully or semi-additive technique on an adhesive-coated surface of a base material, said surface being microporous and treated with a metal ion-containing solution, characterized in that after depositing the conductors the adhesive coating between said conductors is removed partially or completely and substantially without attacking the base material and the conductors.

2. The method of claim 1, characterized in that the said adhesive coating is removed with an alkaline permanganate solution or a chromic acid solution.

3. The method of claim 2, characterized in that said base material having conductors thereon is first treated with an alkaline permanganate solution, and the residues of the manganese compound are subsequently removed from the surface and said surface washed subsequently.

4. The method of claim 3, characterized in that the said base material having conductors thereon is treated

a) in an aqueous solution comprising 50 g/l NaOH and 50 g/l $KMnO_4$ for 5 minutes at 55 to 60°C, and

b) after being rinsed in water, in a hydrochloric acid solution (20%) for 2 minutes, and

c) subsequently washed first in tap water and then in de-ionized water and dried thereafter.

5. The method of claim 4, characterized in that the hydrochloric acid solution (20%) of step b) is replaced by a solution comprising oxalic acid, hydrazine hydrate or another compound suitable for removing manganese compounds.

6. The method of claim 3, characterized in that the steps for removing the adhesive coating are repeated until removal is achieved to the desired extent or completely.

7. The method of claim 2, characterized in that the base material provided with conductors is first treated with an aqueous chromic acid solution, that reaction residues such as hexavalent chromium compounds are removed, and that said steps are followed by a rinsing and drying step.

8. The method of claim 7, characterized in that a solution comprising a reduction agent for hexavalent chromium is used for removing the reaction residues.

9. The method of claim 8, characterized in that the reducing agent is iron(II)sulfate or sodium sulfite or formaldehyde.

10. The method of claims 7 to 9, characterized in that the base material provided with conductors is treated

A) for 2 minutes with a solution of 900 g $CrO_3$ in water at 50°C,

B) subsequently rinsed in water and, following a treatment with a solution of iron(II)sulfate or formaldehyde, is

C) rinsed first in tap water and then in deionized water and dried.

11. Printed circuit boards provided with conductors produced by metal deposition and an adhesive coating in accordance with claim 1, characterized in that the adhesive layer between the conductors is at least partially removed.

12. The printed circuit boards of claim 11, characterized in that the surface between the conductors is completely free of adhesive medium.

## Revendications

1. Procédé semi-additif de production de plaquettes imprimées, suivant lequel on traite un support recouvert d'un produit adhésif et sa surface microporeuse à l'aide d'une solution catalytique contenant des ions métalliques, caractérisé en ce qu'après la pose des pistes conductrices, et dans une phase suivante du processus, la couche adhésive s'étendant entre les pistes est enlevée, soit en partie, soit en entier, sans attaquer, ou pratiquement, le support ou les pistes.

2. Procédé suivant la revendication 1, caractérisé en ce que l'on utilise pour l'enlèvement du produit adhésif une solution alcaline de permanganate, ou d'acide chromique.

3. Procédé suivant la revendication 2, caractérisé en ce que le support équipé des pistes conductrices est traité à l'aide d'une solution alcaline de permanganate, que les résidus manganiques sont ensuite entièrement éliminés de la surface, et que celle-ci est alors rincée.

4. Procédé suivant la revendication 3, caractérisé en ce que le support équipé des pistes conductrices est traité:

a) dans une solution aqueuse contenant 50 g/l de $KMnO_4$ et 50 g/l de NaOH pendant 5 minutes et à une température de 55 à 60°C, et

b) après rinçage à l'eau, dans une solution d'acide chlorhydrique à 20%, pendant 2 minutes et

c) est ensuite rincé d'abord à l'eau de la distribution et ensuite à l'eau déionisée et est finalement séché.

5. Procédé suivant la revendication 4, caractérisé en ce qu'à la phase (b) on utilise, au lieu de la solution d'acide chlorhydrique à 20%, une solution contenant de l'acide oxalique, de l'hydrate d'hydrazine, ou encore un autre produit approprié permettant d'éliminer les composés de manganèse.

6. Procédé suivant la revendication 3, caractérisé en ce que les phases du processus d'enlèvement de la couche adhésive sont répétées jusqu'au degré d'enlèvement souhaité, ou jusqu'à l'enlèvement complet de la couche.

7. Procédé suivant la revendication 2, caractérisé en ce que le support équipé des pistes conductrices est tout d'abord traité dans une solution aqueuse d'acide chromique, et en ce qu'ensuite les résidus de réaction tel que les composés de chrome hexavalents sont éliminés, opération à laquelle succèdent une phase de rinçage et une phase de séchage.

8. Procédé suivant la revendication 7, caractérisé en ce qu'on utilise pour éliminer les résidus de réaction une solution qui contient un agent de réduction du chrome hexavalent.

9. Procédé suivant la revendication 8, caractérisé en ce que l'agent de réduction contient du sulfate ferreux, ou du sulfite de soude ou du formaldéhyde selon le cas.

10. Procédé suivant l'une quelconque des revendications 7 à 9, caractérisé en ce que le support équipé des pistes conductrices:

A) est traité pendant 2 minutes dans un bain à 50°C d'une solution aqueuse de 900 g de $CrO_3$,

B) est ensuite rincé à l'eau et, après traitement dans une solution de sulfate ferreux, ou de sulfite de sodium ou de formaldéhyde selon le cas,

C) est nettoyé tout d'abord à l'eau de la distribution et ensuite à l'eau déionisée, et finalement séché.

11. Plaquettes imprimées du type des circuits imprimés, dont les pistes conductrices sont réalisées par application ou plaquage de métal sur un support recouvert d'un produit adhésif, caractérisées en ce que la couche superficielle d'adhésif séparant les pistes est éliminée tout au moins en partie.

12. Plaquettes imprimées selon la revendication 11, caractérisées en ce que la surface séparant les pistes conductrices est exempte de produit adhésif.